# EUROPÄISCHE PATENTSCHRIFT

(11) **EP 0 776 478 B1**
(45) Veröffentlichungstag und Bekanntmachung des Hinweises auf die Patenterteilung: **12.05.1999**
(21) Anmeldenummer: 95927651.0
(22) Anmeldetag: 09.08.1995
(51) Int. Cl.: G01R 23/16, G01R 31/42

(54) **VERFAHREN UND ANORDNUNG ZUM ÜBERWACHEN VON STROMVERSORGUNGSNETZEN**
METHOD AND DEVICE FOR MONITORING POWER-SUPPLY NETWORKS
PROCEDE ET SYSTEME PERMETTANT DE SURVEILLER DES RESEAUX D'ALIMENTATION EN COURANT

(30) Priorität: 25.08.1994 DE 4430246
(43) Veröffentlichungstag der Anmeldung: 04.06.1997
(73) Patentinhaber: SIEMENS AKTIENGESELLSCHAFT, 80333 München (DE)
(72) Erfinder: KÖCK, Gerd, D-70499 Stuttgart (DE)
(86) Internationale Anmeldenummer: DE9501051
(87) Internationale Veröffentlichungsnummer: WO9606360

(56) Entgegenhaltungen:
- EP-A- 0 477 690
- WO-A-93/03530
- WO-A-94/22025
- DE-A- 3 817 499

## Beschreibung

Die Erfindung betrifft ein Verfahren zum Überwachen von Stromversorgungsnetzen gemäß dem Oberbegriff des Anspruchs 1 und eine entsprechende Anordnung gemäß dem Oberbegriff des Anspruchs 3.

Ein derartiges Verfahren und eine derartige Anordnung sind aus der EP-A-0 477 690 bekannt.

Zur Erkennung und Aufzeichnung von Störungen in Netzen der elektrischen Energieversorgung werden Störschreiber eingesetzt, welche Netzspannungen und/oder -ströme mit einer im Vergleich zur Netzfrequenz hohen Frequenz abtasten, damit auch Störungen höherer Frequenz erfaßt werden. Störungen im Netz können z. B. erkannt werden, indem die Abtastwerte von aufeinanderfolgenden Perioden der Netzspannung miteinander verglichen werden. Da einerseits nicht der gesamte Signalverlauf aufgezeichnet werden kann, da hierzu eine Unzahl von nicht interessierenden Daten gespeichert werden müßte, andererseits aber die ausschließliche Aufzeichnung der Störung im allgemeinen für eine Auswertung hinsichtlich der Entstehung der Störung und ihrer Auswirkung nicht ausreicht, werden neben der Störung die Vorgeschichte und der weitere Verlauf von Strom und Spannung nach ihrem Abklingen aufgezeichnet, und zwar jeweils für einige Sekunden. Die Abtastwerte können in einem Speicher oder Registriergerät für eine spätere Aufzeichnung bereitgestellt werden, oder sie können zu einer Zentrale übertragen, dort gespeichert und ausgewertet werden. Trotz der Beschränkung auf die Störung und die unmittelbare Vorgeschichte und den Nachlauf sind erhebliche Datenmengen zu speichern und/oder zu übertragen. Dauert die Störung z. B. 0,25 sec und will man je 5 sec Vorgeschichte und Nachlauf erfassen, ergibt sich bei einer Abtastrate von 5 kHz, acht Kanälen - je vier für Spannungen und Ströme - und einer Auflösung der Digitalisierung von 16 Bit eine Aufzeichnungsrate von 80 kByte/sec. Für die Beschreibung des angenommenen Störungsverlaufs von 10,25 sec sind demnach 820 kByte erforderlich. Deren Übertragung würde bei einer Übertragungsrate von 300 Bd über 6 Std. und damit untragbar lange dauern. Auch eine höhere Übertragungsrate von 9600 Bd brächte noch keine zufriedenstellend kurze Übertragungszeit.

In der oben erwähnten EP-A-0 477 690 ist daher vorgeschlagen, die Abtastwerte vor dem Speichern oder Übertragen einer Datenreduktion zu unterziehen. Aus der Literatur, z. B. aus dem Buch von K. Riedel "Datenreduzierende Bildcodierung", 1986, Franzis'-Verlag München, sind verschiedene Verfahren der Datenreduktion bekannt.

Aus der DE-A-3 817 499 ist ein Verfahren zum Messen von Funkstörgrößen bekannt, bei dem jeweils nur der je Teilfrequenzbereich auftretende Spitzenwert ermittelt und gespeichert wird, diese Spitzenwerte mit vorgegebenen Grenzwerten verglichen werden und nur diejenigen Spitzenwerte, die den zugehörigen Grenzwert überschreiten, weiterverarbeitet werden.

Aus der WO-A-93 035 30 ist es bekannt, im Rahmen einer Fehlererkennung in Stromrichteranlagen ein Fast-Fourier-Transformations-Glied zusammen mit einem A/D-Wandler zu verwenden, der ein Sample & Hold-Glied umfassen kann.

Der vorliegenden Erfindung liegt die Aufgabe zugrunde, ein Verfahren zum Überwachen von Stromversorgungsnetzen anzugeben, mit dem eine besonders wirksame Datenreduktion erzielt wird. Ferner soll eine Anordnung zur Durchführung dieses Verfahrens geschaffen werden.

Erfindungsgemäß wird diese Aufgabe mit den in den Ansprüchen 1 und 3 angegebenen Maßnahmen gelöst.

Anhand der Zeichnung werden im folgenden die Erfindung sowie Ausgestaltungen und Ergänzungen näher beschrieben und erläutert.
- Figur 1: zeigt das Prinzipschaltbild eines Ausführungsbeispiels der Erfindung.
- In den Figuren 2 und 3: ist die Funktion des Ausführungsbeispiels veranschaulicht.

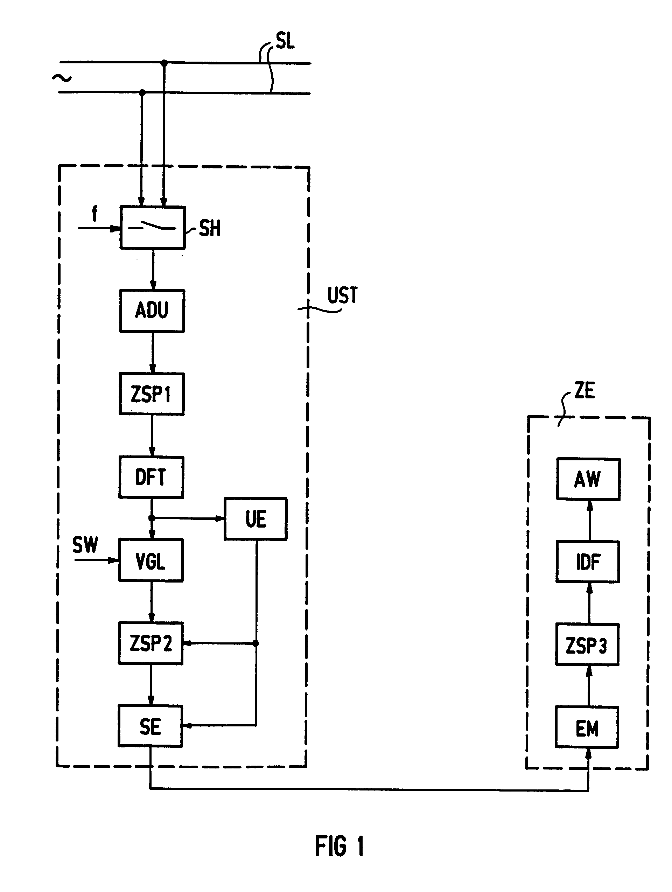

In Figur 1 ist mit SL eine Wechselstromleitung bezeichnet, deren Spannung auf Störungen überwacht werden soll. Im allgemeinen wird nicht nur eine einphasige Spannung überwacht, sondern mehrphasige Spannungen und Ströme, wozu mehrere Kanäle erforderlich sind. Zur Erläuterung der Erfindung ist jedoch die Beschreibung eines einzigen Kanals ausreichend. In Figur 1 ist daher nur ein Kanal einer Unterstation UST dargestellt.

Eine Abtast- und Halteschaltung SH erfaßt mit einer Frequenz f, die ein ganzzahliges Vielfaches der überwachten Spannung, im allgemeinen der Netzfrequenz, ist, im Beispiel 5 kHz, die Spannung auf der Leitung SL. Die Abtastwerte werden von einem Analog-Digital-Umsetzer ADU digitalisiert und in einen ersten Zwischenspeicher ZSP1 eingetragen. Sie werden dort zu Datensätzen von aufeinanderfolgenden Abtastwerten zusamnengefaßt, die eine oder mehrere Perioden der Netzspannung überdecken. Im Ausführungsbeispiel seien es 500 Datensätze, die fünf Perioden überdecken. Es kann daher im allgemeinen nicht mit einer festen Abtastrate gearbeitet werden, vielmehr wird die Abtastrate zweckmäßig auf die Netzfrequenz synchronisiert. Bei hoher Abtastrate kann man diese auch konstant lassen. Es ist aber dann die Anzahl der Datensätze variabel, so daß sie stets ein ganzzahliges Vielfaches der Netzspannungsperiode überdecken. Die Datensätze werden einzeln in einer Einheit DFT einer diskreten Fourier-Transformation unterzogen. Diese ist in der Nachrichtentechnik allgemein bekannt, z. B. ist sie in dem Buch von Norbert Hesselmann "Digitale Signalverarbeitung", 1983, Vogel-Verlag, Seiten 113 bis 117 beschrieben, und braucht daher hier nicht erläutert zu werden. Aus den 500 Abtastwerten im Zeitbereich eines Datensatzes erzeugt die diskrete Fourier-Transformation 250 komplexe Spektralwerte im Frequenzbereich. Die Amplituden der Spektralwerte werden in einem Vergleicher VGL mit einem Schwellwert SW verglichen, der z. B. 0,05 % der größten Amplitude beträgt. Jedenfalls sollte der Schwellwert nur so groß sein, daß durch die Datenkompression praktisch keine Information über den Spannungsverlauf verlorengeht. Die Amplituden der komplexen Spektralwerte werden in bekannter Weise dadurch errechnet, daß aus der Summe der Quadrate des Real- und des Imaginäranteils die Quadratwurzel gezogen wird. Die Spektralwerte, deren Amplituden kleiner als dieser Schwellwert sind, werden auf Null gesetzt bzw. unterdrückt, die größeren Spektralwerte werden in einen zweiten Zwischenspeicher ZSP2 eingetragen.

Im Ausführungsbeispiel setzt die Einheit DFT ständig die Abtastwerte in Spektralwerte um, und zwar mit der Geschwindigkeit, mit der die Abtastwerte in den Zwischenspeicher ZSP1 eingetragen werden. Dessen Größe ist daher so bemessen, daß er zwei Datensätze aufnehmen kann; während die Abtastwerte eines Datensatzes eingetragen werden, wird der zweite Datensatz in der Einheit DFT und im Vergleicher VGL bearbeitet. Der Zwischenspeicher ZSP2 ist so groß, daß er mindestens die Spektralwert-Datensätze aufnehmen kann, mit denen die Vorgeschichte einer Störung beschrieben werden kann. Im allgemeinen wird man ihn jedoch so bemessen, daß er die Datensätze einer Störung einschließlich der Vorgeschichte und des Nachlaufs speichert. In dem angenommenen Beispiel einer Abtastfrequenz f von 5 kHz und 500 Abtastwerten je Datensatz sind zum Beschreiben der Vorgeschichte von 5 sec 50 Datensätze erforderlich, die der Zwischenspeicher ZSP2 mindestens aufnehmen muß. Im Normalbetrieb, wenn keine Störung aufgetreten ist, sind die jeweils letzten 50 Datensätze im Zwischenspeicher ZSP2 enthalten, wobei fortwährend der jeweils älteste durch den jeweils jüngsten ersetzt wird. Tritt eine Störung auf, werden diese 50 Datensätze sowie die daran anschließenden Datensätze der Störung und des Nachlaufs von einem Sender SE zu einem in einer Zentrale ZE enthaltenen Empfänger EM übertragen, der sie in einen Zwischenspeicher ZSP3 einträgt. Eine Einheit IDF rekonstruiert daraus die Abtastwerte mittels einer inversen diskreten Fourier-Transformation, die ebenfalls aus dem vorgenannten Buch "Digitale Signalverarbeitung" bekannt ist. Die rekonstruierten Abtastwerte werden in einer Auswerteeinheit AW ausgewertet.

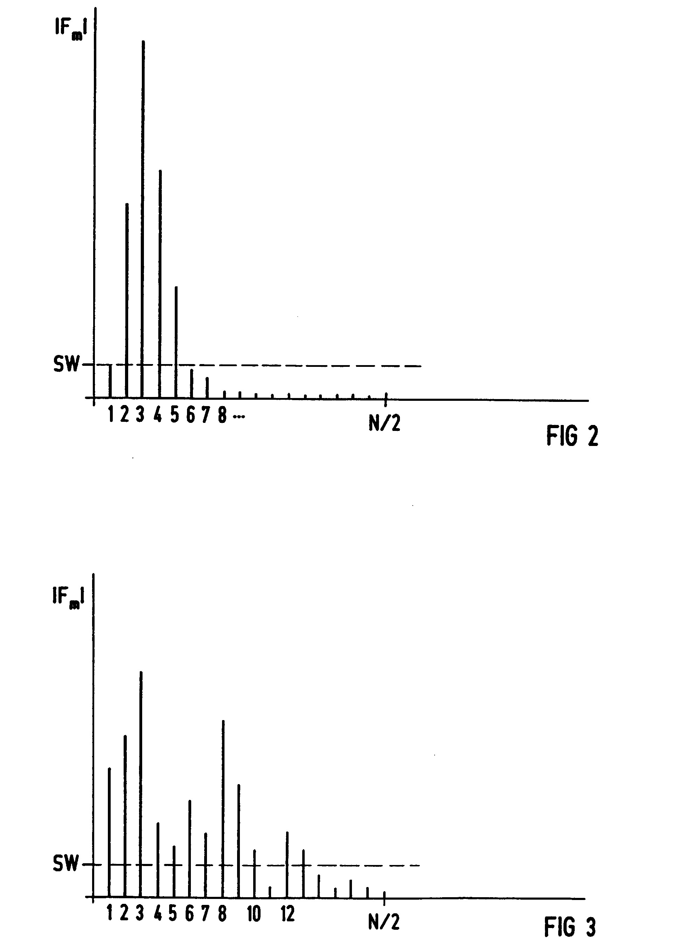

Figur 2 zeigt die Spektralwerte eines Datensatzes bei Störungsfreiheit. Auf der Abszisse sind die Nummern 1, 2 ... N/2 der Spektralwerte aufgetragen, wobei N die Anzahl der Abtastwerte je Datensatz ist. Da nur die Hälfte der Spektralwerte voneinander unabhängig ist, genügt es, nur diese zu behandeln. In dem dargestellten Normalfall haben nur wenige Spektralwerte eine erhebliche Größe. Die anderen kleinen Spektralwerte entstehen zumindest z. T. durch Übertragungsfehler, Quantisierungsrauschen und dergleichen. Es ist daher ein Schwellwert SW eingeführt, die Spektralwerte, die kleiner sind als dieser, werden unterdrückt und nur die größeren weiter bearbeitet. Sie können mit laufenden Nummern 1, 2, 3 ... 250 gekennzeichnet sein, anhand deren sie bei der Rekonstruktion der Abtastwerte identifiziert werden können.

Figur 3 zeigt die Spektralwerte eines Datensatzes im Falle einer Störung. Die Anzahl der Spektralwerte, die den Schwellwert SW übersteigen, ist wesentlich größer als im Normalfall nach Figur 2. Die Datenreduktion wird daher geringer sein. Da aber im allgemeinen die Vorgeschichte und der Nachlauf groß sind im Vergleich zur Dauer der Störung, ergibt sich insgesamt dennoch eine erhebliche Datenreduktion von etwa 50 : 1.

Störungen werden üblicherweise dadurch erkannt, daß die Abtastwerte von aufeinanderfolgenden Perioden der überwachten Spannung bzw. des überwachten Stromes miteinander verglichen werden. Überschreiten die Abweichungen von einer Periode zur nächsten ein vorgegebenes Maß, gilt dies als Störung, und es werden die Datensätze der Vorgeschichte, der Störung und des Nachlaufs gespeichert und/oder zur Zentrale übertragen. Im Ausführungsbeispiel werden Störungen anhand des Frequenzspektrums erkannt. Hierzu werden die Spektralwert-Datensätze einer Überwachungseinheit UE zugeführt. Diese können direkt von der Einheit DFT abgenommen werden, aber auch vom Vergleicher VGL oder dem Zwischenspeicher ZSP2 entnommen werden. Als Kriterium kann das Auftreten von Spektralwerten höherer Ordnung, von z. B. größer als 6, dienen oder das Verhältnis von Spektralwerten höherer Ordnung zu den bei Störungsfreiheit auftretenden Spektralwerten oder auch das Verhältnis der Summe aller Spektralwerte zur Summe der Spektralwerte niedriger Ordnung. Da bei der Überwachung von Netzspannungen auch Änderungen der Amplitude als Störung gemeldet werden sollen, kann auch die Änderung der Amplitude von Spektralwerten niedriger Ordnung ein Störkriterium sein. Hat die Überwachungseinheit UE eine Störung festgestellt, stellt sie im Zwischenspeicher ZSP2 ein Telegramm zusammen, das die Vorgeschichte, die Störung selbst und den Nachlauf beschreibt und gibt dann einen Sendebefehl an den Sender SE.

Da für die inverse diskrete Fourier-Transformation sämtliche (im Beispiel 250) komplexen Spektralwerte erforderlich sind, werden in der Einheit IDF der Zentraleinheit ZE die empfangenen Spektralwerte um die vom Vergleicher VGL unterdrückten durch Konstantwerte, die kleiner als der Schwellwert sind, ergänzt, im einfachsten Fall dadurch, daß sie gleich Null angenommen werden.

## Patentansprüche

1. Verfahren zum Überwachen von Stromversorgungsnetzen,
- bei dem eine Spannung oder ein Strom zyklisch abgetastet und die Abtastwerte digitalisiert werden,
- bei dem Störungen ermittelt werden,
- bei dem die Abtastwerte, welche während einer Störung der Spannung oder des Stromes aufgenommen werden, komprimiert werden, die komprimierten Werte übertragen und/oder gespeichert und zur Auswertung dekomprimiert werden,
**dadurch gekennzeichnet,** daß
- jeweils aus einer ein ganzzahliges Vielfaches der Netzperiode überdeckenden Anzahl von Abtastwerten, die während der Störung sowie eines davor und eines danach liegenden Zeitraumes aufgenommen werden, mittels einer diskreten Fourier-Transformation Spektralwerte errechnet werden,
- zur Datenkomprimierung die Amplituden der Spektralwerte mit einem Schwellwert (SW) verglichen werden und nur die Spektralwerte übertragen und/oder gespeichert werden, die größer als der Schwellwert (SW) sind, und
- zur Datendekomprimierung mit den übertragenen Spektralwerten und konstanten Werten, die kleiner als der Schwellwert (SW), insbesondere Null, sind und welche die durch den Vergleich mit dem Schwellwert (SW) unterdrückten Spektralwerte ersetzen, eine inverse diskrete Fourier-Transformation durchgeführt wird.

2. Verfahren nach Anspruch 1, **dadurch gekennzeichnet,** daß nur die voneinander unabhängigen Spektralwerte übertragen und/oder gespeichert werden.

3. Anordnung zum Überwachen von Stromversorgungsnetzen
- mit einer Erfassungseinrichtung (SH, ADU), welche durch zyklisches Abtasten der Netzspannung und/oder des -stromes Abtastwerte bildet und diese digitalisiert,
- mit einer Datenkomprimierungseinrichtung (DFT, VGL) zur Komprimierung der digitalisierten Abtastwerte,
- mit einer Sendeeinrichtung (SE) zur Übertragung der komprimierten Werte an eine Empfangseinrichtung (EM) oder einen Speicher und
- mit einer Datendekomprimierungseinrichtung (IDF) zur Dekomprimierung der übertragenen komprimierten Werte,
**dadurch gekennzeichnet,**
- daß die Datenkomprimierungseinrichtung (DFT, VGL) jeweils aus einer ein ganzzahliges Vielfaches der Netzperiode überdeckenden Anzahl von Abtastwerten, die während einer ermittelten Störung der Spannung oder des Stromes sowie eines davor und eines danach liegenden Zeitraumes aufgenommen werden, mittels einer diskreten Fourier-Transformation Spektralwerte berechnet, deren Amplituden mit einem Schwellwert (SW) vergleicht und die Spektralwerte, deren Amplituden kleiner als der Schwellwert (SW) sind, unterdrückt,
- daß die Sendeeinrichtung (SE) die Spektralwerte, deren Amplituden größer als der Schwellwert (SW) oder gleich sind, zu der Empfangseinrichtung (EM) oder dem Speicher überträgt, und
- daß die Datendekomprimierungseinrichtung (IDF) aus den übertragenen Spektralwerten mit Hilfe einer inversen diskreten Fourier-Transformation Abtastwerte errechnet, wobei für die von der Datenkomprimierungseinrichtung (DFT, VGL) unterdrückten Spektralwerte Konstantwerte, die kleiner als der Schwellwert (SW) sind, eingesetzt werden.

## Claims

1. Method for monitoring power supply systems,
- where a voltage or a current is cyclically sampled and the sampling values are digitized,
- where disturbances are determined,
- where the sampling values which are accommodated during a disturbance of the voltage or the current are compressed, the compressed values are transmitted and/or stored and are decompressed for evaluation,
characterized in that
- in each case from a number of sampling values which covers an integral multiple of the system period, which sampling values are accommodated during the disturbance and a period before it and a period after it, spectral values are calculated by means of a discrete Fourier Transformation,
- for the data compression the amplitudes of the spectral values are compared with a threshold value (SW) and only those spectral values are transmitted and/or stored which are greater than the threshold value (SW), and
- an inverse discrete Fourier transformation is carried out for the data decompression with the transmitted spectral values and constant values which are smaller than the threshold value (SW), in particular zero, and which replace the spectral values suppressed by the comparison with the threshold value (SW).

2. Method according to claim 1, characterized in that only the spectral values which are independent of each other are transmitted and/or stored.

3. Arrangement for monitoring power supply systems
- with a detection device (SH, ADU) which forms sampling values by means of cyclical sampling of the system voltage and/or the line current and digitizes them,
- with a data compression device (DFT, VGL) for the compression of the digitized sampling values,
- with a transmitting device (SE) for the transmission of the compressed values to a receiving device (EM) or a memory and
- with a data decompression device (IDF) for the decompression of the transmitted compressed values,
characterized in that
- the data compression device (DFT, VGL) calculates spectral values by means of a discrete Fourier Transformation in each case from a number of sampling values which covers an integral multiple of the system period, which sampling values are accommodated during a determined disturbance of the voltage or the current and during a period before it and a period after it, compares the amplitudes of the spectral values with a threshold value (SW) and suppresses those spectral values, the amplitudes of which are smaller than the threshold value (SW),
- the transmitting device (SE) transmits those spectral values, the amplitudes of which are greater than the threshold value (SW) or the same, to the receiving device (EM) or to the memory, and
- the data decompression device (IDF) calculates sampling values from the transmitted spectral values with the aid of an inverse discrete Fourier Transformation, with constant values, which are smaller than the threshold value (SW), being used for the spectral values suppressed by the data compression device (DFT, VGL).

## Revendications

1. Procédé pour surveiller des réseaux d'alimentation en courant, dans lequel
- on échantillonne de façon cyclique une tension ou un courant et on numérise les valeurs échantillonnées,
- on détermine des perturbations,
- on comprime les valeurs échantillonnées qui ont été reçues pendant une perturbation de la tension ou du courant, on transmet les données comprimées et/ou on les mémorise et on les décomprime pour les exploiter,
caractérisé par le fait que
- à chaque fois, à partir d'un nombre, recouvrant un multiple entier de la période de réseau, de valeurs échantillonnées qui sont reçues pendant la perturbation ainsi que pendant un intervalle de temps précédent et pendant un intervalle de temps suivant, on calcule des valeurs spectrales au moyen d'une transformation de Fourier discrète,
- pour la compression de données, on compare les amplitudes des valeurs spectrales à une valeur de seuil (SW) et on transmet et/ou on mémorise seulement les valeurs spectrales qui sont supérieures à la valeur de seuil (SW), et
- pour la décompression de données avec les valeurs spectrales transmises et des valeurs constantes qui sont inférieures à la valeur de seuil (SW), notamment nulles, et qui remplacent les valeurs spectrales supprimées par la comparaison avec la valeur de seuil (SW), on effectue une transformation de Fourier discrète inverse.

2. Procédé selon la revendication 1, caractérisé par le fait que l'on transmet et/ou on mémorise seulement les valeurs spectrales indépendantes les unes des autres.

3. Dispositif pour surveiller des réseaux d'alimentation en courant, comportant
- un dispositif de détection (SH, ADU) qui forme des valeurs échantillonnées en échantillonnant de façon cyclique la tension de réseau et/ou le courant de réseau et qui numérise ces valeurs échantillonnées,
- un dispositif de compression de données (DFT, VGL) qui est destiné à comprimer les valeurs échantillonnées numérisées,
- un dispositif d'émission (SE) qui est destiné à transmettre les valeurs comprimées à un dispositif de réception (EM) ou à une mémoire et
- un dispositif de décompression de données (IDF) qui est destiné à décomprimer les valeurs comprimées transmises,
caractérisé par le fait que
- à chaque fois à partir d'un nombre, recouvrant un multiple entier de la période de réseau, de valeurs échantillonnées qui sont reçues pendant une perturbation déterminée de la tension ou du courant ainsi que pendant un intervalle de temps précédent et pendant un intervalle de temps suivant, le dispositif de compression de données (DFT, VGL) calcule au moyen d'une transformation de Fourier discrète des valeurs spectrales dont les amplitudes sont comparées à une valeur de seuil (SW) et il supprime les valeurs spectrales dont les amplitudes sont inférieures à la valeur de seuil (SW),
- le dispositif d'émission (SE) transmet les valeurs spectrales dont les amplitudes sont supérieures ou égales à la valeur de seuil (SW) au dispositif de réception (EM) ou à la mémoire, et
- le dispositif de décompression de données (IDF) calcule des valeurs échantillonnées à partir des valeurs spectrales transmises et à l'aide d'une transformation de Fourier discrète inverse, des valeurs constantes inférieures à la valeur de seuil (SW) étant utilisées pour les valeurs spectrales supprimées par le dispositif de compression de données (DFT, VGL).
